# EUROPEAN PATENT APPLICATION

(11) **EP 4 389 850 A1**
(43) Date of publication of application: **26.06.2024**
(21) Application number: 22306929.5
(22) Date of filing: 19.12.2022
(51) Int. Cl.: C09K 11/02, C09K 11/65, G01N 21/00

(54) **FUNCTIONALIZED FLUORESCENT NANODIAMONDS AND THEIR USE FOR THE DETECTION AND/OR QUANTIFICATION OF BIOLOGICAL FREE RADICALS**

(71) Applicant: Wainvam-E, 56270 Ploemeur (FR)
(72) Inventor: EBABE ELLE, Etienne Raymond, 56270 Ploemeur (FR); PERRE, Agathe, 29170 Pleuven (FR)
(74) Representative: Novagraaf Technologies

(57) **Abstract**

The present invention relates to a nanodiamond having Nitrogen-Vacancy (NV) centers, which is functionalized with a linker bond to a spin trap.

It also relates to an in vitro method for detecting and/or quantifying biological free radicals in a sample, and to the use of a nanodiamond of the invention for assessing antioxidant efficacy of a molecule in a sample, or for detecting and/or quantifying biological free radicals in a sample.

The present invention also concerns the use of the nanodiamond for monitoring a disease in which free radicals are involved, by detecting and/or quantifying biological free radicals in a biological sample of a patient.

## Description

### Technical field

The present invention refers to a functionalized nanodiamond having Nitrogen-Vacancy (NV) centers, its uses, and to an in vitro method for detecting and/or quantifying biological free radicals in a sample.

Therefore, the present invention has utility in biology applications, in particular in cosmetic, pharmaceutic, ecotoxicology and food industries fields.

In the description below, the references into brackets ([ ]) refer to the listing of references situated at the end of the text.

### Background of the Invention

Oxidative stress is defined as a pathological state characterized by an imbalance between antioxidants (as vitamins, polyphenols, endogenous enzymes, among others) and free radical species (such as superoxide anion, hydroxyl radical), in favour of the latter. Free radical species are characterized by one or more unpaired electrons on the external layer of the molecule, which gives it a great instability resulting in an oxidation of the biological material, especially proteins, lipids or DNA.

Depending on its intensity, this oxidation phenomenon can lead to extremely deleterious effects for the organism. Our lifestyle (smoking, alcoholism, obesity), our environment (pollution, exposure to radiation) and our bad eating habits contribute to an abnormal production of these free radical species. Oxidative stress acts as an initiator or amplifier in many disorders such as eye diseases, neurodegenerative diseases, diabetes, renal failure, cardiovascular diseases, melanoma and other types of cancers.

The detection/quantification of free radical species is therefore crucial to prevent these abnormalities, which is relatively complex due to their high instability, their lifetime being of the order of one second. Another difficulty is to have an agent able to cross physiological membranes, reach their site of action for stabilized free radicals and could be easily detected without generating toxicity.

Measuring free radicals can be done by fluorescent probes such as hydroxyphenyl fluorescein (HPF) or terephthalate (Th), which react with the species they detect and transform into a fluorescent form. Other like lucigenin emits chemiluminescence in the presence of species, but they are not sensitive for every type of Reactive Oxygen Species (ROS), they are not cell permeable, they are sensible to the light and their reactivity can decrease over time (Perona Martinez et al. ([1])).

Other fluorescents probes like DCFHDA (2',7'-Dichlorodihydrofluorescein diacetate), DHR (dihydrorhodamine) or MitoSOX (Mitochondrial Superoxide Indicators) are cell permeable and easy to use. However, they may present an artefactual amplification of the fluorescent intensity via redox-cycling mechanism involving an intermediate radical like DCF° or DHR°, have intermediate with similar fluorescence spectral parameters, HPLC (High Performance Liquid Chromatography) analyses of products may be necessary for proper identification of probe and they may have a mitochondrial toxicity (Kalyanaraman Balaraman et al. ([2])).

Among the techniques that allow the detection of free radicals, Electronic Paramagnetic resonance (EPR) is among the most used. It is usually coupled with molecules known as "spin trap" that allow to increase the lifetime of biological radical species. There are different families of spin traps:
1- Linear spin traps with the nitrone group reacting with the free radicals as with PBN (N-tert-butyl-α-phenylnitrone), POBN (α-(4-Pyridyl 1-oxide)-N-tert-butylnitrone), EPPyN (N-2-(2-ethoxycarboyl-propyl)-α-(4-pyridyl) nitrone) and others
2- The cyclic spin traps with the nitrone part included in a ring are represented by EMPO (2-Ethoxycarbonyl-2-methyl-3,4-dihydro-2H-pyrrole-1-oxide), DEPMPO (5-diethoxyphosphoryl-5-methyl-1-pyrroline-N-oxide), CAMPO (5-carbamoyl-5-methyl-1-pyrroline-N-oxide) and others. 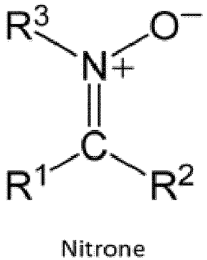
3- Spin traps with a nitroso groups as reactive part as in the case of MNP (2-methyl-2-nitrosopropane) or DBNBS (3,5-dibromo-4-nitrosobenzene sulfonic acid).

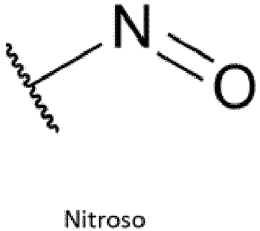

Electron Paramagnetic Resonance is a local physical measurement technique that provides information about the nature of the magnetic species present, as well as information about their concentrations. It is based on the property of certain electrons to absorb and re-emit energy from electromagnetic radiation when placed in a magnetic field. Only unpaired or single electrons, present in radical chemical/biological species as well as in salts and transition metal complexes, have this ability. The majority of the stable chemical species possessing pairs of paired electrons, this technique will make it possible to highlight the chemical/biological species possessing unpaired electrons in a very specific way in solids, liquids or gases and to determine the environment of the latter.

The principle of EPR is based on the Zeeman effect, which designates the separation of an atomic energy level of energy defined by an atom or a molecule into several energetic sub-levels that can be observed spectroscopically in the presence of a magnetic field.

Then, under the action of a second magnetic field (microwave field) perpendicular to the first and of much lower amplitude, having a frequency v, a photon with energy hv (with h = Planck constant) can be absorbed or emitted if the energy separation between the two levels concerned is equal to the energy of the photon. Mathematically, the specific value of the magnetic field at which the resonance phenomenon occurs is determined.

A spin resonance spectrum can theoretically be obtained either by fixing a static magnetic field and fluctuating the frequency v of the microwave field or the reverse. In general, most spectrometers work by allowing the magnetic field to vary while the frequency v is fixed.

An absorption spectrum and a first derivative of the absorption are obtained at a fixed frequency and by fluctuating the external static magnetic field. The majority of EPR spectrometers use a synchronous detection, that is to say that the magnetic field is modulated around a central value.

Each signal recorded in this way is characteristic of the magnetic element present and the interactions that this element experiences (V. Marchand et al. ([3])). This information is obtained from:
- The value of the resonance field (which informs about the g-factor of the magnetic ion in question),
- The area under the absorption curve (which informs, among other things, on the number of spins present),
- The half-width to half-height of the absorption curve (which informs about the interactions felt by the spins).

The number of signals indicates the number of sites or interactions with one (or) more nuclear spin.

Most of the time, the exploitation of EPR spectra requires a simulation step to be able to deduce the different information concerning the environment of the paramagnetic elements present, to follow the evolution of the device according to the experimental conditions and to measure a concentration as long as a standard is available.

The disadvantages of EPR are:
- Interpretation of spectra sometimes delicate and difficult.
- The choice of probes complicated. Indeed, the EPR technique uses spin traps/probe to stabilize free radicals. However, depending on the spins traps used, their concentration must be high enough to detect a signal but at the same time, the presence of spin traps and in particular in these concentrations generates a background noise in the EPR which results in very irregular spectra and therefore an approximate interpretation of the data.
- Detection at the level of a single cell impossible because of the lack of sensitivity.

Thus, a need exists of alternative products overcoming these issues. The present invention fulfills these and other needs.

### Description of the invention

After extensive research, the Applicant has managed to develop functionalized nanodiamonds for detecting and quantifying biological free radicals, which can be used both outside and inside cells, have increased cellular bioavailability and reduced toxic effects.

The Applicant has found surprisingly that fluorescent nanodiamond (FND) with Nitrogen-Vacancy (NV) centers can be linked to spin traps via a linker, thereby allowing to control the distance between the functionalized nanodiamonds and the free radicals and increasing sensitivity of the method for detecting and quantifying biological free radicals.

Advantageously, interpretation of spectra is made easier, as by implementing the invention, the quantification of free radical concentration is not based on an interpretation of a spectrum like in the EPR.

Another advantage of the invention is that the detection at the level of a single cell is made possible, as the T1 relaxometry technique coupled with nanodiamonds-spin trap of the invention is sensitive enough to isolate and quantify the free radical signal obtained from a single nanodiamond unlike EPR.

Accordingly, in a first aspect, the present invention provides a nanodiamond having Nitrogen-Vacancy (NV) centers, which is functionalized with a linker bond to a spin trap.

"Nanodiamonds" refers herein to diamonds having nanoscale. Advantageously, the nanodiamonds may have a size included between 50nm and 150nm, or 70nm and 100 nm. Advantageously, the nanoscale of the nanodiamonds allows them to be internalized and/or located inside cells, in particular living cells, without disturbing the cell homeostasis. Another advantage of nanodiamonds is their biocompatibility, which mean the viability of the cell and the production of reactive oxygen species are not modified when the nanodiamond is uptaken by the cell.

"Functionalizing" refers herein to the linkage of chemicals or biomolecules at the surface of the nanodiamonds. Advantageously, functionalization of nanodiamonds make them able to bind to a linker. Advantageously, functionalization of the surface carboxyl groups of nanodiamonds may be realized by any method known in the art for this purpose. For example, in a first step, carboxylated groups on the nanodiamonds may be activated using 1-ethyl-3-(-3-dimethylaminopropyl) carbodiimide hydrochloride (EDC) and Sulfo-N-hydroxysuccinimide (Sulfo-NHS). The activated carboxyl groups are made to react with NH₂ terminated ligand or amine part of the linker via amide linkage between the carboxyl and amine groups. Advantageously, functionalization increases cellular bioavailability and reduces spin trap doses, thus limiting toxic effects.

Optionally, the nanodiamonds may be carboxylated. "Carboxylated" refers herein to a carboxyl group at the surface of nanodiamonds, that are able to be functionalized using carbodiimide chemistry. For example, carboxyl group may be present at the surface of fluorescent nanodiamonds due to chemical treatment.

"linker" refers herein to any element able to create a bond between the nanodiamond and the spin trap. The linker may be of any kind known by the skilled person. It may be for example chosen among carbon chains such as polyethylene glycol, protein complexes such as biotin-streptavidin complex, and antibodies. Spin trapping is an analytical technique usually employed for the detection and identification of short-lived free radicals through the use of EPR spectroscopy. Indeed, when the half-life of radicals is too short to detect with EPR, compounds known as spin traps are used to react covalently with the radical products and form more stable adduct that will also have paramagnetic resonance spectra detectable by EPR spectroscopy. However, it is difficult to link a nanodiamond directly to a spin trap. The inventors surprisingly managed to link a spin trap to a nanodiamond by using a linker. Furthermore, the linker coupled to the spin trap allows to keep the free radicals very close to the nanodiamonds thus allowing their detection in a more sensitive and precise way.

"spin trap" refers herein to any compound able to react covalently with free radicals and to form more stable radical called "spin adduct" (Germán Barriga-González et al. ([4])). Advantageously, spin traps may increase the lifetime of free radicals and the presence of nanodiamonds close to these species ease the measurement of their magnetic field and then their concentrations. Spin trap may be chosen among linear spin traps with a nitrone group, cyclic spin traps with nitrone group included in a ring, and spin traps with a nitroso group. Linear spin traps may be chosen among, for example, PBN (N-tert-butyl-α-phenylnitrone), POBN (α-(4-Pyridyl 1-oxide)-N-tert-butylnitrone) and EPPyN (N-2-(2-ethoxycarboyl-propyl)-α-(4-pyridyl) nitrone). Cyclic spin traps with the nitrone part included in a ring may be chosen among EMPO (2-Ethoxycarbonyl-2-methyl-3,4-dihydro-2H-pyrrole-1-oxide), DEPMPO (5-diethoxyphosphoryl-5-methyl-1-pyrroline-N-oxide) and CAMPO (5-carbamoyl-5-methyl-1-pyrroline-N-oxide). Spin traps with a nitroso groups as reactive part may be chosen among MNP (2-methyl-2-nitrosopropane) and DBNBS (3,5-dibromo-4-nitrosobenzene sulfonic acid).

"Nitrogen-Vacancy (NV) centers" refers herein to defects that are artificially created in nanodiamonds. A carbon atom in the diamond's crystal lattice is replaced by a nitrogen atom (defect, N), and a neighboring lattice site is left empty (vacancy, V) to form NV center. NV centers may be detected by any methods of the state of the art known for this purpose. These defects exhibit red fluorescence properties under green light excitation. The level of fluorescence depends on the external magnetic field and as free radicals generate magnetic noise, a link can be made between the magnetic noise and the free radical concentration. However, the magnetic field emitted by the free radical decreases in 1/r³ with r the distance between the diamond and the free radical. Thus, ideally, the free radical should be as close as possible to the ND to obtain a better signal. As explained above, the nanodiamonds of the invention allow to control the distance of the free radical to the ND and therefore to obtain an optimized signal. This is how the concentration of free radicals can be measured in real time in a given sample.

In one embodiment, the linker may be the complex biotin-streptavidin, and the spin trap may be 5-(Diethoxyphosphoryl)-5-methyl-1-pyrroline-N-oxide molecule. Advantageously, in this embodiment, the nanodiamond may be functionalized with the streptavidin protein via an amide linkage between an amine group of the streptavidin protein and a COOH group of the nanodiamond, and the streptavidin protein may be linked to the biotin protein grafted to the 5-(Diethoxyphosphoryl)-5-methyl-1-pyrroline-N-oxide molecule. More particularly, this functionalized nanodiamond may be obtained from a process comprising the steps of:
- functionalizing nanodiamonds having Nitrogen-Vacancy (NV) centers with a streptavidin protein via an amide linkage between an amine group of the streptavidin protein and a COOH group of the nanodiamond, and
- linking said streptavidin protein with a biotin protein grafted to a 5-(Diethoxyphosphoryl)-5-methyl-1-pyrroline-N-oxide molecule.
In this process, functionalizing nanodiamonds may comprise the steps of:
- activating surface carboxyl groups of the nanodiamonds using N-ethyl-N'-(-3-dimethylaminopropyl) carbodiimide hydrochloride (EDC) and N-hydroxysuccinimide (NHS) or Sulfo-NHS,
- reacting said activated carboxyl groups of the nanodiamonds with NH2 of streptavidin protein to form the amide linkage between carboxyl and amine groups.

In another embodiment, the linker may be PEG (Polyethylene glycol) style carbon chains as a linker. For example, if working with amino-PEG-acid, the amine part may bind to the surface of the nanodiamond, and the acid part, when activated by carbodiimide chemistry, would create an amide bond in contact with a nitrogen. Some spin traps have a nitrogen in addition to the nitrogen used for the reactive moiety as in the case of EPPyN or CAMPO, which can react with this linker particularly well.

In another embodiment, the linker may be a spin trap specific antibody. This may be done, for example, by functionalizing the nanodiamond surface with the antibody via an amide bond. Once complete, the functionalized NDs are brought into contact with the spin trap and the antibody recognizes it. The result is an ND-Antibody-Spin trap. For example, with DMPO spin trap, the anti-DMPO monoclonal antibody can be used, that is commercially available from Thermofisher. In the end, the ND-(anti DMPO)-DMPO is obtained. The same applies with any other spin trap.

In another aspect, the present invention provides an *in vitro* method for detecting and/or quantifying biological free radicals in a sample, the method comprising the steps of:
- bringing functionalized nanodiamonds as defined above into contact with the sample,
- illuminating NV centers with green light, and
- detecting and/or quantifying intensity of red fluorescence of the NV centers in the sample,
wherein red fluorescence of the NV centers depends on the free radical concentration in the sample.

The sample may be any sample likely to contain free radicals. It may be a biological sample, a cosmetic product, a food product or a pharmaceutical product. As the detection and/or quantification is performed in a sample, the method is an in vitro method. The sample may be in solid or liquid form, such as a solution.

When they are illuminated with green light (wavelength = 532nm), FNDs emit a red fluorescence that can be measured by any mean known in the state of the art, for example with an optical detector. The optical intensity of red luminescence depends on the quantum electron spin state in which the NV center is located: the zero-electron spin state is more luminescent than non-zero electron spin states. The distribution of spin states in the fundamental state and thus the level of fluorescence, depends on the magnetic environment. When magnetic field varies randomly temporally and spatially, it is magnetic noise generated by free radicals. To detect it, a relaxometry protocol is performed. The higher the magnetic noise, the lower the relaxation time; so, the higher the free radical concentration, the lower the T1. Therefore, the method of the invention may comprise a step of performing a relaxation protocol.

As explained above, in the method of the invention, the functionalized nanodiamonds may be localized intracellularly and/or extracellularly. For example, the functionalized nanodiamonds may be able to penetrate inside a cell, thereby allowing intracellular detection and/or quantification of biological free radicals in the sample.

In another aspect, the invention relates to the use of a nanodiamond as defined above for assessing antioxidant efficacy of a molecule in a sample, or for detecting and/or quantifying biological free radicals in a sample.

As explained above, the sample may be chosen among a biological sample, a cosmetic product, a food product and a pharmaceutical product.

In another aspect, the invention relates to the use of a nanodiamond as defined above, for monitoring a disease in which oxidative stress is involved, by detecting and/or quantifying biological free radicals in a biological sample of a patient. The disease may be any disease in which free radicals are involved, as for example type 2 diabetes, hypertension and atherosclerosis.

This invention is further illustrated by the following examples with regard to the annexed drawings that should not be construed as limiting.

### Brief description of the figures

- Figure 1: represents the schematic illustration of A: functionalization of Streptavidin protein on carboxylated FNDs. B: Linkage between FND-Streptavidin and spin trap.
   - Figure 2: represents the schematic illustration of reaction between spin trap functionalized onto FNDs and free radical.
   - Figure 3: represents a pulse sequence for relaxometry protocol, as explained in Example 2.
   - Figure 4: represents raw results of relaxometry measurement: fluorescence decay curve (Normalized fluorescence vs. extinction time).
   - Figure 5: represents a schematic drawing of the set up to measure relaxation time T1 of NV centers.
   - Figure 6: represents a schematic illustration of the effect of the antioxidant on a radical species.

### Examples

### Example 1: Functionalisation of nanodiamonds (NDs) with spin trap Nanodiamonds are functionalized with streptavidin protein.

This protein is functionalized on the surface of the carboxylated NDs using carbodiimide chemistry. The amine group of the protein is bound to the COOH groups of the carboxylated NDs.

In a first step, the carboxylated groups on the NDs are activated using 1-ethyl-3(-3-dimethylaminopropyl) carbodiimide hydrochloride (EDC) and N-hydroxysuccinimide (NHS) or Sulfo-NHS, as described by Muhammad et al. ([5]).

The activated carboxyl groups are made to react with NH2 of Streptavidin to form FND-Streptavidin via amide linkage between carboxyl and amine groups. When FND-Streptavidin is brought into contact with Biotin-DEPMPO, a non-covalent bond is formed between streptavidin and biotin.

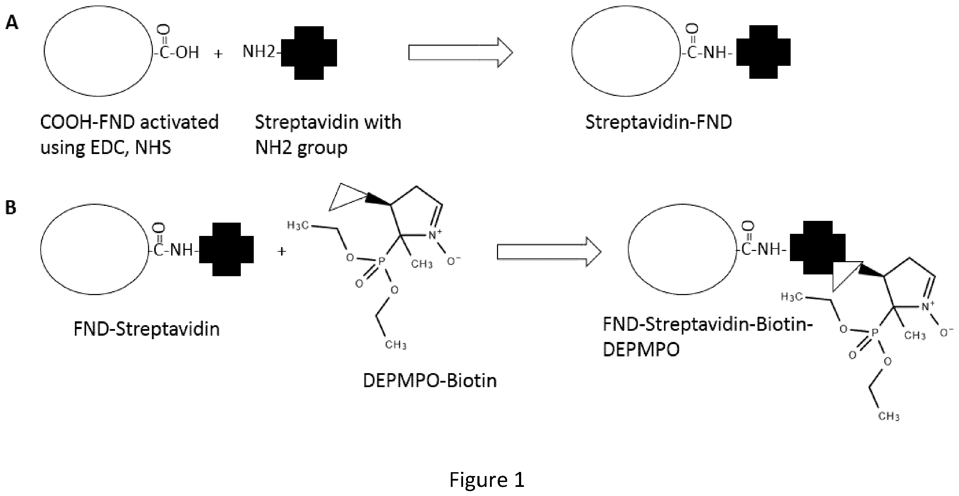

The method of Streptavidin functionalization and spin trap linkage are illustrated schematically in figure 1.

### Example 2: Measurement of free radicals with FND-Spin trap

Functionalized NDs with a spin trap on the surface as obtained in Example 1 are brought into contact with free radicals.

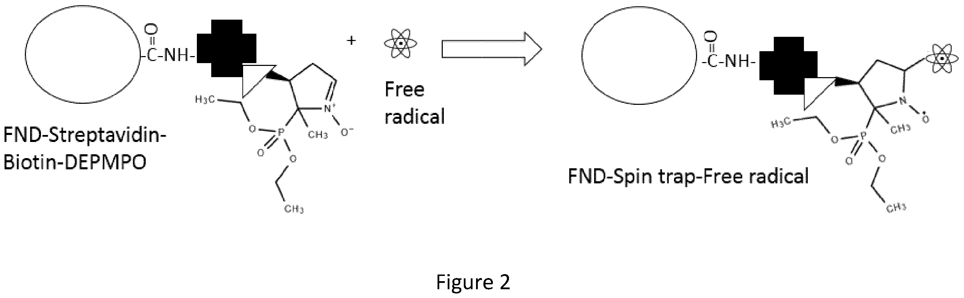

As shown on Figure 2; the double bond linked to the nitrogen in the 5-atom ring gives an electron to the free radical which combined with single electron of the free radical, creates a bond between the latter and the spin trap in the end, a much more stable species is obtained, with a longer lifetime, while remaining radical.

When they are illuminated with green light (wavelength = 532nm), FNDs emit a red fluorescence that can be measured with an optical detector. The optical intensity of red luminescence depends on the quantum electron spin state in which the NV center is located: the zero-electron spin state is more luminescent than non-zero electron spin states. The distribution of spin states in the fundamental state and thus the level of fluorescence, depends on the magnetic environment.

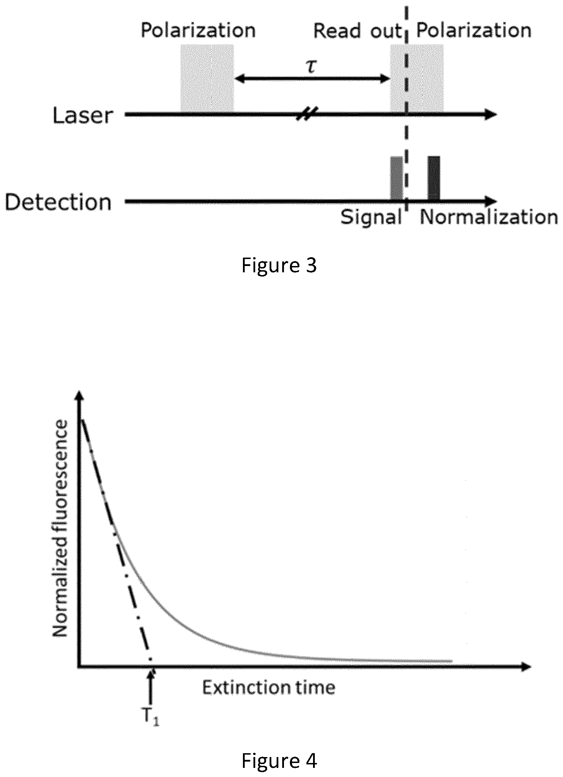

When magnetic field varies randomly temporally and spatially, it is called magnetic noise. To detect it, a relaxometry protocol is performed. The longitudinal relaxation time T1 corresponds to the time it takes for a system in which some electrons have been polarized in a particular state to return to its equilibrium state. T1 measurement consists of several cycles of three distinct steps, illustrated on Figure 3:
1. The NV centre is excited with green light to polarize the spins of the centre NV from equilibrium distribution to the null state of the ground state.
2. The light is then turned off during an extinction time τ. The spins evolve freely and tend to return to their state of equilibrium.
3. A new green light pulse reads the state of the NV centre's spins thanks to the red fluorescence signal. The higher the signal, the more the spins are in the null state, which means that they have not had time to return to the state of equilibrium.

This process is repeated by gradually increasing the extinction time. When the extinction time is very short, not all polarised spins have time to move and therefore the fluorescence is maximal. The longer the dark time, the longer it will take for the spins to return to the zero-spin state and the fluorescence will decrease. The experimentally obtained curve of fluorescence decay (Figure 4) is fitted with an exponential model. From this fit, a characteristic time, that is relaxation time T1, is extracted by the tangent.

When T1 is high, most of the spins have not been perturbed by an external field and have remained in the zero state. When T1 is short, it means that the non-zero spin levels have been populated by an external field, i.e. there are many free radicals. To conclude, the higher the magnetic noise, the lower the T1. In our case, the free radicals concentration is linked to magnetic noise measured by T1 relaxometry. So, the higher the free radical concentration, the lower the T1.

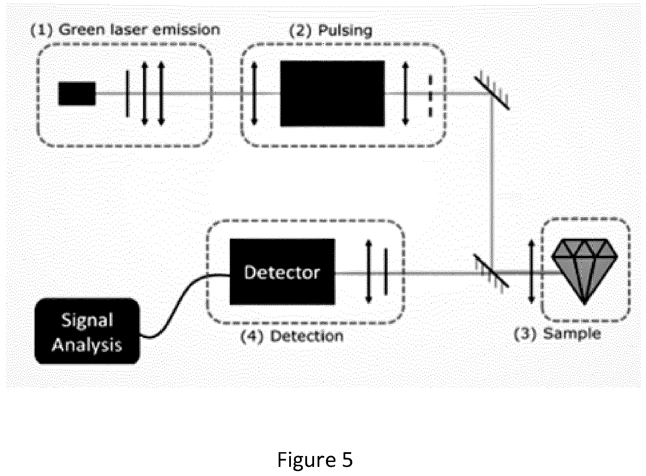

The set-up used to perform this T1 measurement is illustrated on Figure 5.

Green light is emitted and pulsed. The wavelength is included between 500 and 550 nm. The light source is directly pulsed via programming and acquisition card. This subsystem is integrated into the light source. A dichroic mirror is then used to separate the incident green light from the backscattered red light. Then, detection of the red fluorescence signal, between 600 and 800 nm, of the order of nW over a period of a few hundred nanosecond. A fitting algorithm extracts the relaxation time T1.

The measured T1 is related to free radical concentration, as the higher the concentration of free radicals, the lower the T1. This link can be determined with a physical model or/and thanks to an experimental calibration curve. This calibration curve corresponds to the measurement of T1 as a function of the free radical concentration. In this way, when a sample is measured with an unknown free radical concentration, the T1 value can be evaluated and plotted on the calibration curve to determine the free radical concentration present in the sample.

### Example 3: evaluation of antioxidant efficacity

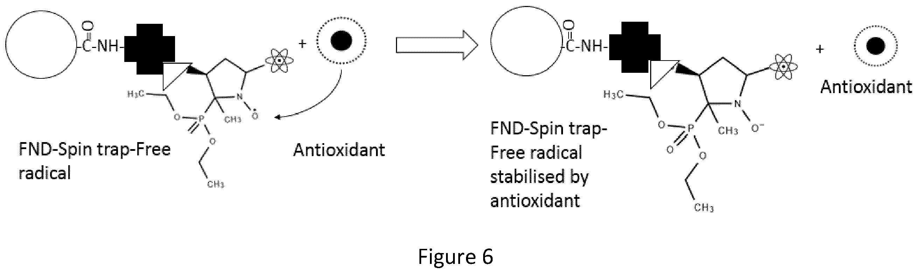

One application is the evaluation of antioxidant efficacity. Once the functionalised NDs have reacted with the free radicals as explained in Example 2, an antioxidant is added. It is a species capable of giving or taking one electron and remaining stable. This antioxidant stabilises the radical species, as shown on Figure 6. As a result, there is no longer a magnetic field around the ND and therefore the T1 increases.

### Reference List

1. Perona Martinez, Felipe, Anggrek Citra Nusantara, Mayeul Chipaux, Sandeep Kumar Padamati, et Romana Schirhagl. « Nanodiamond Relaxometry-Based Detection of Free-Radical Species When Produced in Chemical Reactions in Biologically Relevant Conditions ». ACS Sensors 5, no 12 (24 décembre 2020): 3862 69.
2. Kalyanaraman Balaraman, Victor Darley-Usmar, Kelvin J.A. Davies, Phyllis A. Dennery, Henry Jay Forman, Matthew B. Grisham, Giovanni E. Mann, Kevin Moore, L. Jackson Roberts, et Harry Ischiropoulos. « Measuring Reactive Oxygen and Nitrogen Species with Fluorescent Probes: Challenges and Limitations ». Free Radical Biology and Medicine 52, no 1 (janvier 2012): 1 6.
3. V. Marchand, N. Charlier, J. Verrax, P. Buc-Calderon, P. Levêque, B. Gallez. (2017). Use of a cocktail of spin traps for fingerprinting large range of free radicals in biological systems.
4. Germán Barriga-González et al. : « Spin Trapping: An Essential Tool for the Study of Diseases Caused by Oxidative Stress », Current Topics in Medicinal Chemistry, 2015, 15, 484-495.
5. Muhammad et al. Simultaneous determination of insulin and glucose in human serum based on dual emissive fluorescent nano-aptasensor of carbon dots and CdTe/CdS/ZnS quantum dots. Sensors & Actuators: B. Chemical 292 (2019) 321-330.

## Claims

1. A nanodiamond having Nitrogen-Vacancy (NV) centers, which is functionalized with a linker bond to a spin trap.

2. A nanodiamond according to claim 1, wherein said linker is chosen among carbon chains such as polyethylene glycol, protein complexes such as biotin-streptavidin complex, and antibodies.

3. A nanodiamond according to claim 1 or 2, wherein said spin trap is chosen among linear spin traps with a nitrone group reacting with the free radicals, cyclic spin traps with nitrone group included in a ring, and spin traps with a nitroso group.

4. A nanodiamond according to claim 3, wherein said spin trap is selected among PBN (N-tert-butyl-α-phenylnitrone), POBN (α-(4-Pyridyl 1-oxide)-N-tert-butylnitrone), EPPyN (N-2-(2-ethoxycarboyl-propyl)-α-(4-pyridyl) nitrone), EMPO (2-Ethoxycarbonyl-2-methyl-3,4-dihydro-2H-pyrrole-1-oxide), DEPMPO (5-diethoxyphosphoryl-5-methyl-1 -pyrroline-N-oxide), CAMPO (5-carbamoyl-5-methyl-1-pyrroline-N-oxide), MNP (2-methyl-2-nitrosopropane) and DBNBS (3,5-dibromo-4-nitrosobenzene sulfonic acid).

5. A nanodiamond according to anyone of the preceding claims, wherein the linker is biotin-streptavidin, and the spin trap is 5-(Diethoxyphosphoryl)-5-methyl-1-pyrroline-N-oxide molecule.

6. A nanodiamond according to claim 5, which is functionalized with the streptavidin protein via an amide linkage between an amine group of the streptavidin protein and a COOH group of the nanodiamond, and wherein the streptavidin protein is linked to the biotin protein grafted to the 5-(Diethoxyphosphoryl)-5-methyl-1-pyrroline-N-oxide molecule.

7. An in vitro method for detecting and/or quantifying biological free radicals in a sample, the method comprising the steps of:
- bringing functionalized nanodiamonds as defined in the preceding claims into contact with the sample,
- illuminating NV centers with green light, and
- detecting and/or quantifying intensity of red fluorescence of the NV centers in the sample,
wherein red fluorescence of the NV centers depends on the free radical concentration in the sample.

8. A method according to claim 7, comprising a step of performing a relaxation time relaxometry measurement.

9. A method according to claim 7 or 8, wherein said functionalized nanodiamonds are localized intracellularly and/or extracellularly.

10. A method according to anyone of claims 7 to 9, wherein the step of quantifying intensity of red fluorescence of the NV centers is repeated over time to follow a kinetic reaction.

11. A process for preparing a nanodiamond as defined in claim 5, comprising the steps of:
- functionalizing nanodiamonds having Nitrogen-Vacancy (NV) centers with a streptavidin protein via an amide linkage between an amine group of the streptavidin protein and a COOH group of the nanodiamond, and
- linking said streptavidin protein with a biotin protein grafted to a 5-(Diethoxyphosphoryl)-5-methyl-1-pyrroline-N-oxide molecule.

12. Use of a nanodiamond as defined in anyone of claims 1 to 6 for assessing antioxidant efficacy of a molecule in a sample, or for detecting and/or quantifying biological free radicals in a sample.

13. Use according to claim 12, wherein said sample is chosen among a biological sample, a cosmetic product, a food product and a pharmaceutical product.

14. Use of a nanodiamond as defined in anyone of claims 1 to 6, for monitoring a disease in which free radicals are involved, by detecting and/or quantifying biological free radicals in a biological sample of a patient.

15. Use according to claim 14, wherein said disease is chosen among type 2 diabetes, hypertension and atherosclerosis.
